# EUROPEAN PATENT SPECIFICATION

(11) **EP 0 470 839 B1**
(45) Date of publication and mention of the grant of the patent: **25.01.1995**
(21) Application number: 91307283.1
(22) Date of filing: 08.08.1991
(51) Int. Cl.: H05K 3/46, H05K 1/03, H05K 1/09, H01L 23/15, H01L 23/538, C03C 14/00

(54) **Ceramic substrate having wiring incorporating silver**
Keramisches Substrat mit Silber enthaltender Verdrahtung
Substrat céramique à conducteurs contenant de l'argent

(30) Priority: 08.08.1990 JP 209484/90
(43) Date of publication of application: 12.02.1992
(73) Proprietor: NEC CORPORATION, Tokyo (JP)
(72) Inventor: Kata, Keiichiro, c/o NEC Corporation, Tokyo (JP); Shimada, Yuzo, c/o NEC Corporation, Tokyo (JP)
(74) Representative: Orchard, Oliver John

(56) References cited:
- EP-A- 0 016 306
- US-A- 4 714 687
- US-A- 4 748 136

## Description

The present invention relates to a ceramic substrate, and, more particularly, to a ceramic substrate for mounting thick-film hybrid ICs or high speed LSI elements.

As a result of the recent tendency to reduce the size and weight of electronic devices, such as communication equipment, home-use electronic devices, computers, etc., to increase the number of functions that they can perform, to make them with a high-density of components and with high-reliability, the wiring technique for connecting together semiconductor chips has become more important, as has the high integration and high speed of operation of the chips. Substrate materials, can be roughly classified as belonging to an organic resin group, a metal group and a ceramic group. Amongst these, the ceramic group is frequently used in fields in which high quality, high reliability and long duration are required. Amongst ceramic materials, alumina has been widely used in view of its electrical characteristics and its cost. However, in order to use the green sheet multilayer method by which three dimensional wiring is possible and which has advantages in enabling higher density to be realised, the conductor material of the wiring layer is limited to metals such as tungsten or molybdenum, whose specific resistance is relatively high, since it is necessary to heat them to temperatures as high as the sintering temperature of alumina i.e. of 1500 to 1600°C.

In view of this limitation, a low sintering temperature ceramic, which is a composite material of glass and a host ceramic, has been developed. Since this composite material has a low melting point, a metal material may be used as the wiring layer whose specific resistance is low and which material cannot be sintered simultaneously with the sintering of ceramic material. A metal material, such as gold, silver and copper, does not occupy a large part of the hybrid IC substrate market in view of the high cost of gold and the instability against oxidation of copper and thus it can be said that silver or silver containing material is mainly used as a wiring material. However, a wiring layer made of silver, or of material containing silver has a migration problem, and to cope with this problem a silver alloy with palladium, or the like, has been used. No publication of the constitution of this alloy is known.

Although the proportion of silver to palladium has been usually selected as 80 : 20 in view of the requirements of anti-migration, solder-wettability, solder loss, adhesiveness and resistance value, it has been desired to use a conductive material containing a high silver ratio in order to lower the resistance value and improve the solder wettability and ageing characteristics. Solder loss, bad matching with cross over glass, degradation of solder wettability due to surface galvanization and silver migration can be minimised in various ways and thus there is a high possibility that such a material may be used in future developments.

On the other hand, a multi-layered glass ceramic substrate in which the wiring length can be reduced and a high density wiring is possible is of interest for use in multi-chip packages which are used in large, high speed computers and in which a large number of LSI chips are mounted on a single substrate. As a wiring material in such a multi-layered glass ceramic substrate, the above-mentioned silver or material containing silver may be used. However, in order to further increase the mounting density, there is a tendency for the size of the substrate to become large. In order to sinter such large substrates in the same way as those of the conventional size, it is necessary to make the sintering time longer. However, this may increase the diffusion of silver from the wiring into the glass substrate during sintering process, with the resulting problem that there is a considerable degradation in various characteristics of wiring made of silver or of material containing silver.

In the specification of US-A- 4 748 136, which was published on May 31, 1988, there was proposed a ceramic-glass-metal composite in which silver particles were discontinuously dispersed throughout the composite for enhancing the flow characteristics of the composite.

A feature of the present invention is the provision of a substrate having wiring which hardly changes its characteristics and which is of a silver series.

In a particular embodiment of the present invention, there is provided a ceramic substrate which comprises a ceramic body having a major face. The ceramic body contains silver of 0.1 to 2.5 percent by weight. A wiring layer is formed on the major face of the ceramic body and is made of silver and of material containing silver.

In the preferred embodiment of the present invention, a ceramic substrate includes a ceramic body which is constituted by a plurality of ceramic insulating layers stacked upon each other. Each of the ceramic insulating layers contains silver of 0.1 to 2.5 percent by weight and has upper and lower faces. A wiring pattern made of silver or of material containing silver is formed on the upper and/or the lower faces of the ceramic insulating layers such that one group of wiring layers of the wiring pattern is positioned within the ceramic body. The ceramic body or the ceramic insulating layer consists essentially of a main material and the silver, and the main material may consist essentially of ceramic, such as alumina (aluminium oxide, Aℓ₂O₃), and glass, such as borosilicate series lead glass, or of quartz glass and cordierite and borosilicate glass. The silver is contained in the ceramic body in particles, each particle having preferably 1 to 5 »m diameter, with the silver being dispersed substantially uniformly in the main material such that at every portion of the ceramic body or ceramic insulating layer, the percentage ratio of the silver weight to the total weight of the main material and the silver is 0.1% or more and 2.5% or less.

Since the ceramic substrate of the preferred embodiment of the present invention includes a ceramic which contains between 0.1 - 2.5% by weight of silver, any diffusion of the conductive material containing silver as its main constituent and forming the wiring to the ceramic insulating layer of the substrate is restricted during a sintering process, resulting in more stable wiring conductor characteristics after sintering.

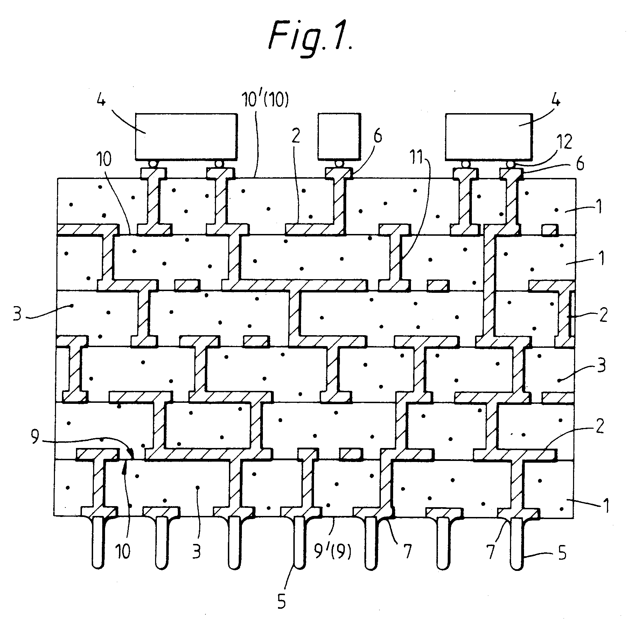

Embodiments of the present invention will now be described, by way of example, with reference to the accompanying Fig. 1, which is a cross-sectional view of a substrate.

Referring to Fig. 1, there is shown a cross-sectional view of a ceramic substrate. The ceramic substrate includes a ceramic body having six ceramic insulating layers 1 stacked upon each other, and a wiring pattern 2. The wiring pattern 2 is selectively formed on the upper faces 10 and on the lower faces 9 of respective ceramic insulating layers 1 and extends through holes 11 formed in the layers 1 to connect electrically the respective wiring layers of the pattern 2 on the upper and lower sides or faces of the layers 1. The wiring pattern 2, which is in a 3-dimensional form, further includes first electrodes 6 which are on the upper face 10′ of the top ceramic insulating layer 1 and which are designed to be bonded to a semiconductor element 4, such as an IC or an LSI chip by means of solder 12, and second electrodes which are on the lower face 9′ of the bottom ceramic insulating layer 1 and which are designed to be bonded to terminal leads 5, including input and output terminal leads. The ceramic insulating layers 1 contain fine silver particles 3, represented by black dots or circles of 0.1 - 2.5% silver by weight.

In a first embodiment of the present invention to be described, a ceramic substrate will be described which is prepared using binary powder material of alumina and lead borosilicate glass as the raw materials. Since the sintering temperature of this composite material is as low as 900°C, a silver-containing paste can be used as the conductive material of the wiring to be sintered simultaneously with the substrate. As an example, an alloy of silver and palladium was used in one case. There are further merits in the use of ceramic and glass as the main material in that its dielectric properties, (e.g. constant) is lower than that of alumina, that its thermal expansion coefficient is substantially matched to that of elements of Si, that its mechanical strength is improved by anorthite phase deposition due to the reaction between alumina and glass, and that it restricts the migration of silver.

In a case in which the green sheet lamination which is advantageous in high density mounting is used as the manufacturing method for this substrate, raw glass powder is crushed to control the particle size and then mixed with alumina in the proportion of 45% of glass to 55% of alumina, both by weight. Further, after adding a predetermined amount of fine silver particles having an average size of 1 - 5 »m to the mixture and mixing it therewith, it is mixed with an organic vehicle to obtain a slurry mixture. Then, a green sheet having a desired thickness is produced by using the slip casting film forming method and a shaped product is prepared with the formation of through-holes, with a silver-palladium conductor pattern used as a wiring pattern printing and through-hole filling printing, with lamination and with thermal pressing. The shaped product is sintered after the removal of the binder, resulting in a multi-layered wiring substrate.

Now, the reason why the ratio of fine silver particles 3 to be added is limited to the range 0.1 - 2.5% by weight will be described. First, the amount of such silver particles has to be enough to prevent silver from diffusing into the glass phase forming the insulating layer during the sintering process. However, when the amount added is too large, the characteristics of the insulating layer, particularly its insulating characteristics, are degraded rapidly. In these circumstances, the effect of fine silver particles on the characteristics of the silver-containing conductor and on the insulating layer have been studied over a range in which the ratio of fine silver particles added was varied from 0 to 10% by weight of silver and 95% by weight. The specific resistances of conductors containing 100% by weight of silver and 95% by weight of silver were calculated from the resistance and cross sectional area values after sintering and were selected as the conductor characteristics; shrinkage and density of the sintered body were calculated on the Archimedean principle; the bending strength was calculated according to the three-point bending method; dielectric constant and dielectric loss were measured at 1 MHz; the insulation resistance was measured when a voltage of 50 V was applied; and the breakdown voltage and the average thermal line expansion coefficient in a range from room temperature to 350°C were selected as the insulating layer characteristics. The results are shown in Table 1. In the case in which no fine silver particle was added to the insulating layer, the specific resistance of the conductor varied considerably and was unstable. It was observed that, when fine silver particles of 0.1% by weight were added to the insulating layer, the diffusion of silver

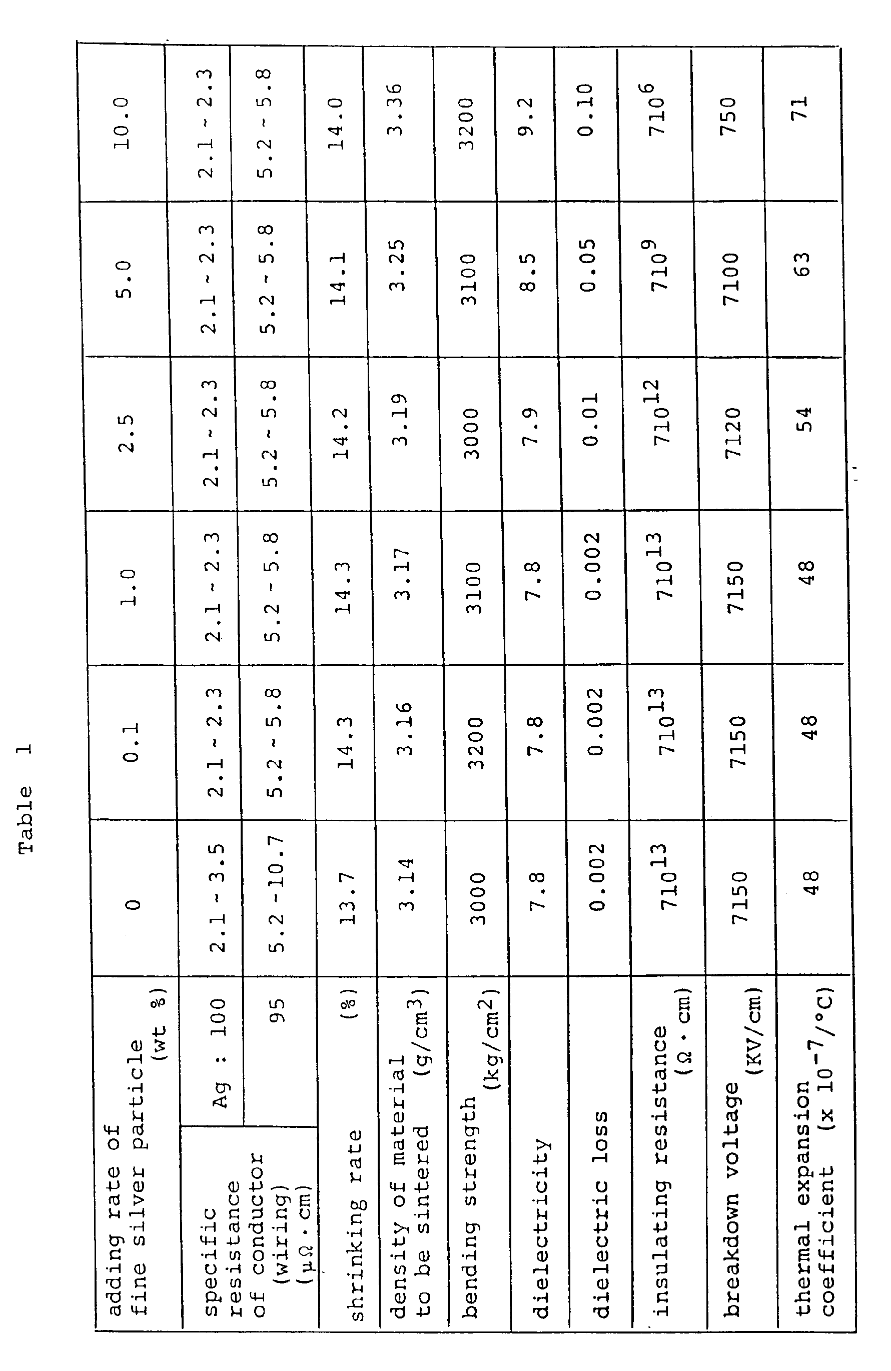

from the conductor during the sintering process was restricted and the specific resistance became stable. On the other hand, for the characteristics of the insulating layer, when the ratio of fine silver particles added exceeded 2.5% by weight, degradation was observed. Particularly, the insulating characteristics such as the insulating resistance and the breakdown voltage were degraded abruptly. Therefore, the ratio of added fine silver particles with which the characteristics of the silver-containing conductor forming the wiring were stabilized without affecting the characteristics of the insulating layer adversely are defined as being within a range from 0.1 to 2.5% by weight.

In a second embodiment of the present invention, a ternary ceramic including quartz glass, cordierite and borosilicate glass is used as the raw material for a ceramic substrate and this embodiment will be described below. Since the sintering temperature of this composite material is as low as 900°C, it is possible to use a silver-containing paste as both a sintering conductor and as a wiring layer, simultaneously. In a particular example, an alloy of silver and palladium was used, as in the first embodiment described above. Further, this material has dielectric properties (e.g. a constant) as low as 4.4, which is advantageous in improving transmission speeds, and its thermal expansion coefficient is well matched to that of an Si element. Its anti-bending strength is relatively high and is 1600 kg/cm. In the particular example it was mixed in ratios by weight of 20:15:65. The effects of this material on the characteristics of both the conductor and the insulating layer were checked by adding fine silver particles over a range which varied from 0 to 10% by weight. The results are listed in Table 2, from which it is clear that the optimum ratio is 0.1 to 2.5% by weight as in the first described embodiment of the present invention.

As described hereinbefore, since, the conductor of the wiring layer contains silver as a main constituent and the ceramic insulating layer contains fine silver particles in the range of 0.1 to 2.5% by weight, the diffusion of silver contained in the conductor into the ceramic insulating layer during the sintering process is restricted and thus the characteristics of the wiring conductor after sintering are stabilized.

It will be understood that, although the invention has been described, by way of example, with reference to particular embodiments, variations and modifications may be made within the scope of the appended claims.

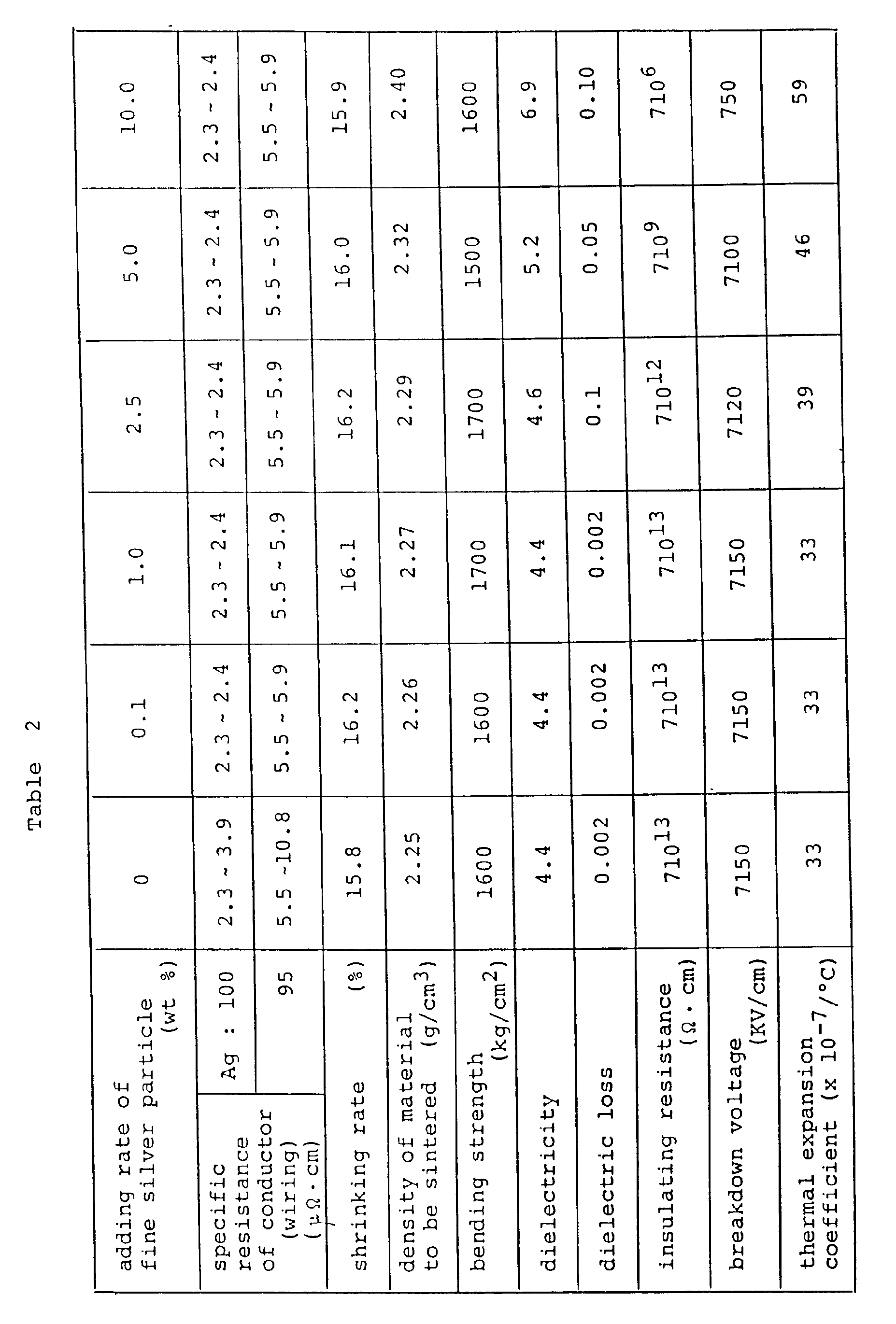

## Claims

1. A ceramic substrate including a ceramic body having a major face, the ceramic body containing silver of between 0.1 to 2.5 percent by weight, and a wiring layer formed on the major face of the ceramic body and made of silver or a material containing silver.

2. A ceramic substrate including a ceramic body, the ceramic body having a plurality of ceramic insulating layers stacked upon each other, each of the ceramic insulating layers containing silver of between 0.1 to 2.5 percent by weight and having upper and lower faces, and a wiring pattern made of silver or of a material containing silver formed on the upper and/or the lower face(s) of the ceramic insulating layers such a wiring layer of the wiring pattern is positioned within the ceramic body.

3. A ceramic substrate as claimed in claim 2, in which through-holes are formed in a ceramic insulating layer from an upper face to a lower face, and in which wiring layers of the wiring pattern fill the through-holes to electrically connect the wiring layer of the wiring pattern formed on the upper face of the insulating layer and the wiring layer of the wiring pattern formed on the lower face of the insulating layer.

4. A ceramic substrate as claimed in claim 2, in which the wiring pattern includes a first electrode wiring formed on the upper face of the uppermost ceramic insulating layer of the stacked ceramic insulating layers for bonding a semiconductor element thereto, and a second electrode wiring formed on the lower face of the lower-most ceramic insulating layer of the stacked ceramic insulating layers for bonding terminals, including input and output terminals, thereto.

5. A ceramic substrate as claimed in either claim 1 or claim 2, in which the ceramic body includes a main material and silver, the main material being essentially alumina and glass.

6. A ceramic substrate as claimed in claim 5, in which the glass is a borosilicate series lead glass.

7. A ceramic substrate as claimed in either claim 1 or claim 2, in which the silver in the body is in particles, each of the particles having a grain diameter of between 1 to 5 »m.

8. A ceramic substrate as claimed in either claim 1 or claim 2, in which the ceramic body includes a main material and silver, the main material being essentially of quartz glass, cordierite and a borosilicate glass.

## Patentansprüche

1. Keramisches Substrat mit einem Keramikkörper mit einer Hauptfläche, wobei der Keramikkörper zwischen 0,1 und 2,5 Gew.-% Silber enthält, und mit einer Verdrahtungsschicht, die auf der Hauptfläche des Keramikkörpers ausgebildet und aus Silber oder einem Silber enthaltenden Material hergestellt ist.

2. Keramisches Substrat mit einem Keramikkörper, wobei der Keramikkörper eine Anzahl von keramischen Isolierschichten aufweist, die übereinander angeordnet sind, wobei jede der keramischen Isolierschichten zwischen 0,1 und 2,5 Gew.-% Silber enthält und obere und untere Flächen aufweist und wobei eine Verdrahtungsstruktur aus Silber oder aus einem Silber enthaltenden Material auf der/den oberen und/oder der/den unteren Fläche(n) der keramischen Isolierschichten ausgebildet ist, so daß eine Verdrahtungsschicht der Verdrahtungsstruktur innerhalb des Keramikkörpers positioniert ist.

3. Keramisches Substrat nach Anspruch 2, bei dem durchgehende Löcher in einer keramischen Isolierschicht von einer oberen Fläche bis zu einer unteren Fläche ausgebildet sind und bei dem Verdrahtungsschichten der Verdrahtungsstruktur die durchgehenden Löcher ausfüllen, um die Verdrahtungsschicht der Verdrahtungsstruktur, die auf der oberen Fläche der Isolierschicht ausgebildet ist, und die Verdrahtungsschicht der Verdrahtungsstruktur, die auf der unteren Fläche der Isolierschicht ausgebildet ist, elektrisch zu verbinden.

4. Keramisches Substrat nach Anspruch 2, bei dem die Verdrahtungsstruktur aufweist: eine erste Elektrodenverdrahtung, die auf der oberen Fläche der obersten keramischen Isolierschicht der übereinander angeordneten keramischen Isolierschichten ausgebildet ist, zum Verbinden eines Halbleiterelements mit ihr und eine zweite Elektrodenverdrahtung, die auf der unteren Fläche der untersten keramischen Isolierschicht der übereinander angeordneten keramischen Isolierschichten ausgebildet ist, zum Verbinden von Anschlüssen, einschließlich Eingangs- und Ausgangsanschlüssen, mit ihr.

5. Keramisches Substrat nach einem der Ansprüche 1 oder 2, bei dem der Keramikkörper ein Hauptmaterial und Silber aufweist, wobei das Hauptmaterial im wesentlichen Aluminiumoxid oder Glas ist.

6. Keramisches Substrat nach Anspruch 5, bei dem das Glas ein Borosilikat-Bleiglas ist.

7. Keramisches Substrat nach einem der Ansprüche 1 oder 2, bei dem das Silber im Körper aus Partikeln besteht, wobei jedes der Partikel einen Korndurchmesser zwischen 1 und 5 »m aufweist.

8. Keramisches Substrat nach einem der Ansprüche 1 oder 2, bei dem der Keramikkörper ein Hauptmaterial und Silber aufweist, wobei das Hauptmaterial im wesentlichen Quarzglas, Kordierit und Borosilikatglas ist.

## Revendications

1. Substrat en céramique comportant un corps de céramique ayant une face principale, le corps de céramique contenant de l'argent en une proportion de 0,1 à 2,5 % en poids, et une couche de câblage formée sur la face principale du corps de céramique et constituée d'argent ou d'un matériau contenant de l'argent.

2. Substrat en céramique comportant un corps de céramique, le corps de céramique ayant une multitude de couches isolantes de céramique empilées les unes sur les autres, chacune des couches isolantes de céramique contenant de l'argent en proportion de 0,1 à 2,5 % en poids et ayant des faces supérieures et inférieures et un motif de câblage constitué d'argent ou d'un matériau contenant de l'argent formé sur la face ou les faces supérieures et/ou inférieures des couches isolantes de céramique de sorte qu'une couche de câblage des motifs de câblage soit positionnée à l'intérieur du corps de céramique.

3. Substrat en céramique selon la revendication 2, dans lequel des trous de traversée sont formés dans une couche isolante de céramique à partir d'une face supérieure jusqu'à une face inférieure et dans lequel les couches de câblage des motifs de câblage remplissent les trous de traversée pour connecter électriquement la couche de câblage du motif de câblage formée sur la face supérieure de la couche isolante et la couche de câblage du motif de câblage formée sur la face inférieure de la couche isolante.

4. Substrat en céramique selon la revendication 2, dans lequel le motif de câblage comporte un premier câblage d'électrodes formé sur la face supérieure de la couche isolante de céramique la plus en haut, des couches isolantes de céramique empilées pour souder un élément semi-conducteur à celles-ci et un second câblage d'électrodes formé sur la face inférieure de la couche isolante de céramique la plus en bas, des couches isolantes de céramique empilées pour souder des bornes, comportant des bornes d'entrée et de sortie à celles-ci.

5. Substrat en céramique selon soit la revendication 1, soit la revendication 2, dans lequel le corps de céramique comporte un matériau principal et de l'argent, le matériau principal étant essentiellement de l'oxyde d'aluminium et du verre.

6. Substrat en céramique selon la revendication 5, dans lequel le verre est du verre de plomb de la série des borosilicates.

7. Substrat en céramique selon soit la revendication 1, soit la revendication 2, dans lequel l'argent dans le corps est en particules, chacune des particules ayant un diamètre de grain situé entre 1 à 5 »m.

8. Substrat en céramique selon soit la revendication 1, soit la revendication 2, dans lequel le corps de céramique comporte un matériau principal et de l'argent, le matériau principal étant essentiellement du verre en quartz, du verre de cordiérite et du verre de borosilicate.
